# EUROPEAN PATENT APPLICATION

(11) **EP 2 437 325 A1**
(43) Date of publication of application: **04.04.2012**
(21) Application number: 10780588.9
(22) Date of filing: 20.05.2010
(51) Int. Cl.: H01L 51/42

(54) **ORGANIC PHOTOELECTRIC CONVERSION ELEMENT**

(30) Priority: 27.05.2009 JP 2009127492
(71) Applicant: Sumitomo Chemical Company, Limited, Tokyo 104-8260 (JP)
(72) Inventor: SEIKE, Takahiro, Tsukuba-shi Ibaraki 305-0005 (JP)
(74) Representative: Vossius & Partner
(86) International application number: PCT/JP2010/058952
(87) International publication number: WO 2010/137634

(57) **Abstract**

A high photoelectric conversion efficiency is provided by an organic photoelectric conversion element comprising a first electrode, a second electrode and an active layer, wherein the active layer is located between the first electrode and the second electrode and contains an electron-donating compound and an electron-accepting compound, and the active layer side of the first electrode surface is treated with a coupling agent followed by a lyophilic treatment.

## Description

### TECHNICAL FIELD

The present invention relates to an organic photoelectric conversion element.

### BACKGROUND ART

An organic thin film solar cell is a solar cell in which an active layer containing an organic compound is located between an anode and a cathode. Compared with an inorganic solar cell having an active layer including an inorganic material such as silicon, the organic thin film solar cell can likely be manufactured with significantly reduced cost, and it has been drawing attention as a lower-cost solar photovoltaic power element.

As the organic thin film solar cell, an organic photoelectric conversion element having a laminated structure is known, where, on top of an anode including tin oxide-added indium oxide (ITO), a cathode formed by laminating sequentially a layer including poly(ethylenedioxythiophene) (PEDOT), an active layer including poly(3-hexylthiophene) which is a conjugated polymer compound and [6,6]-phenyl C61 butyric acid methyl ester (PCBM) which is a fullerene derivative, a calcium layer and an aluminum layer is placed (See Advanced Functional Materials, 2007, vol. 17, pp. 1636-1644). However, its photoelectric conversion efficiency is not so high.

### DISCLOSURE OF THE INVENTION

The present invention provides an organic photoelectric conversion element having high photoelectric conversion efficiency.

The organic photoelectric conversion element of the present invention comprises a first electrode, a second electrode and an active layer, wherein the active layer is located between the first electrode and the second electrode and contains an electron-donating compound and an electron-accepting compound, and the active layer side of the first electrode surface is treated with a coupling agent followed by conducting a lyophilic treatment.

The present invention further provides a method for manufacturing the organic photoelectric conversion element, wherein the manufacturing method includes a step of preparing a first electrode by making a coupling agent come into contact with a surface of an electrode followed by conducting a lyophilic treatment on the surface which the coupling agent contacted.

The present invention further provides an image sensor having the organic photoelectric conversion element.

Hereinafter, the present invention will be described in detail.

In the present invention, the first electrode is obtained by making a coupling agent come into contact with a surface of an electrode followed by conducting a lyophilic treatment on the surface. The first electrode has high conductivity, and is used as a conductive layer which collects electric charges generated in the active layer during light irradiation. The first electrode may be used either in the form of an independent solid of a conductive layer alone, or in the form of being prepared on a solid substrate.

An electrode material for forming the first electrode of the present invention is preferably a metal or a conductive oxide that can form a strong chemical bond with a coupling agent. Examples of the metal include Al, Cu, Ag, Ti and others. A different metal may be added to the electrode material in order to enhance stability. Examples of the conductive oxide include ITO, FTO (fluorine-added tin oxide), IZO (indium oxide-added zinc oxide), ATO (antimony-added tin oxide) and others, which exhibit high conductivities near room temperature.

The coupling agent used in the present invention is a molecule obtained by bonding one or more hydrophobic organic groups and a group which forms a hydroxyl group by a reaction with water, to an atom of Si, Al, Zr, Ti or the like. Examples of the group which forms a hydroxyl group by a reaction with water include an alkoxy group, an acetoxy group, a halogen atom and others. Examples of the hydrophobic organic group include an alkyl group (for example, an isostearoyl group), a vinyl group, a group having an epoxy structure, a styryl group, a methacryloyl group, an acryloyl group, an amino group and others. Compared with the group which forms a hydroxyl group by a reaction with water, the hydrophobic organic group is not easily hydrolyzed, and turn into a hydroxyl group when a lyophilic treatment is conducted.

Examples of a coupling agent having a Si atom include vinyltrichlorosilane, vinyltrimethoxysilane, vinyltriethoxysilane, 2-(3,4-epoxycyclohexyl)ethyltrimethoxysilane, 3-glycidoxypropyltrimethoxysilane, 3-glycidoxypropylmethyldiethoxysilane, 3-glycidoxypropyltriethoxysilane, p-styryltrimethoxysilane, 3-methacryloxypropylmethyldimethoxysilane, 3-methacryloxypropyltrimethoxysilane, 3-methacryloxypropylmethyldiethoxysilane, 3-methacryloxypropyltriethoxysilane, 3-acryloxypropyltrimethoxysilane, N-2-(aminoethyl)-3-aminopropylmethyldimethoxysilane, N-2-(aminoethyl)-3-aminopropyltrimethoxysilane, N-2-(aminoethyl)-3-aminopropyltriethoxysilane, 3-aminopropyltrimethoxysilane, 3-aminotriethoxysilane, 3-triethoxysilyl-N-(1,3-dimethyl-butylidene)propylamine, N-phenyl-3-aminopropyltrimethoxysilane, N-(vinylbenzyl)-2-aminoethyl-3-aminopropyltrimethoxysilane hydrochloride, 3-ureidopropyltriethoxysilane, 3-chloropropyltrimethoxysilane, 3-mercaptopropylmethyldimethoxysilane, 3-mercaptopropyltrimethoxysilane, bis(triethoxysilylpropyl) tetrasulfide, 3-isocyanatopropyltriethoxysilane, tetramethoxysilane, tetraethoxysilane, methyltrimethoxysilane, methyltriethoxysilane, dimethyltriethoxysilane, phenyltriethoxysilane, hexamethyldisilazane, hexyltrimethoxysilane, decyltrimethoxysilane, butyltrichlorosilane, cyclohexyltrichlorosilane, decyltrichlorosilane, dodecyltrichlorosilane, octyltrichlorosilane, octadecyltrichlorosilane, tetradecyltrichlorosilane and others. Particularly, octadecyltrichlorosilane is preferable because the electrode can be uniformly coated with the coupling agent.

Examples of a coupling agent having an Al atom include aluminum isopropylate, mono sec-butoxyaluminum diisopropylate, aluminum sec-butyrate, aluminum ethylate, ethylacetoacetatoaluminum diisopropylate, aluminum tris(ethylacetoacetate), alkylacetoacetatoaluminum diisopropylate, monoacetylacetonatoaluminum bis(ethylacetoacetate), aluminum tris(acetylacetonate), aluminum monoisopropoxymonooleoxyethylacetoacetate, cyclic aluminum oxide isopropylate, cyclic aluminum oxide octylate, cyclic aluminum oxide stearate and others.

Examples of a coupling agent having a Zr atom include zirconium n-propylate, zirconium n-butyrate, zirconium tetraacetylacetonate, zirconium monoacetylacetonate, zirconium bisacetylacetonate, zirconium monoethylacetoacetate, zirconium acetylacetonate bisethylacetoacetate, zirconium acetate, zirconium monostearate and others.

Examples of a coupling agent having a Ti atom include tetraisopropyl titanate, tetra-n-butyl titanate, butyl titanate dimer, tetra(2-ethylhexyl)titanate, tetramethyl titanate, titanium acetylacetonate, titanium tetraacetylacetonate, titanium ethylacetoacetate, titanium octanediolate, titanium lactate, titanium triethanolaminate, polyhydroxytitanium stearate and others.

The treatment of coating a coupling agent on the electrode is a treatment of making a coupling agent come into with the active layer side of the electrode surface. The coupling agent may be used in the form of a liquid as it is at room temperature, or in the form of a solution including a coupling agent and a solvent. Many of coupling agents have low stability in the air, so that they are generally used in the form of a solution including a coupling agent and a solvent. Methods of contact include an immersion method and an application method.

The immersion method refers to a method in which an electrode is immersed in a liquid coupling agent, or in a solution containing a coupling agent. In order to hydrolyze a group which forms a hydroxyl group when reacted with water, water needs to be present on the electrode surface. Water may be supplied to the electrode surface from the exterior; however, the coupling agent may selectively be attached to the electrode surface by solely using the adsorbed water on the electrode surface in the reaction. Thus, the coupling agent is preferably used in the form of a solution including a coupling agent and a solvent. The solvent used to dissolve the coupling agent is preferably a linear alkane or an aromatic solvent having high hydrophobicity, and more preferably a dehydrated linear alkane. From the viewpoint of suppressing drastic hydrolysis of a group which forms a hydroxyl group when reacted with water by the reaction between the solution and moisture in the air, the immersion treatment is preferably conducted under the low moisture concentration environment, and more preferably in an enclosed space equipped with a moisture removing equipment.

Excessive deposits of the coupling agent on the immersion-treated electrode can be removed by washing using a solvent which can dissolve the coupling agent. The solvent used for the washing is not necessarily the same as the solvent contained in the solution including a coupling agent, and a hydrophobic solvent having sufficiently low water concentration may be used.

After the washing is conducted, the coupling agent-coated electrode is heat treated at a temperature of 100 to 150°C, and thus the coupling agent can be more firmly immobilized on the electrode surface.

An application method may as well be used as a method of making a liquid coupling agent or a solution including a coupling agent and a solvent come into contact with an electrode surface. When used as the solution including a coupling agent and a solvent, a solvent preferably used in the immersion method, and a solvent in which a group which forms a hydroxyl group when reacted with water in the coupling agent is hydrolyzed, and in which no precipitation is not generated, may be used as a solvent for application. Particularly, strong acid water, a mixed solvent of water and alcohol, and an alcohol solvent are preferable. Examples of the application method include a slit coating method, a capillary coating method, a gravure coating method, a microgravure coating method, a bar coating method, a knife coating method, a spin coating method and others. By utilizing these methods, a film having a uniform thickness in the whole surface is obtained.

Excessive deposits of the coupling agent on the coupling agent-applied electrode can be removed by washing using the same solvent as the one contained in the solution including a coupling agent. The solvent used for the washing is not necessarily the same as the solvent contained in the solution including a coupling agent, and a hydrophobic solvent having sufficiently low water concentration may be used.

After the washing is conducted, the coupling agent-coated electrode is heat treated at a temperature of 100 to 150°C, and thus the coupling agent can be more firmly immobilized on the electrode surface.

In the present invention, lamination of the active layer is achieved by contacting a coupling agent with the active layer side of the electrode surface, followed by conducting a lyophilic treatment on the surface.

The "lyophilic treatment" in the present specification means a treatment which enhances the affinity of a target surface to an application liquid (or its solvent) including materials forming an active layer, and refers to a method for oxidizing an organic group contained in a coupling agent. For the lyophilic treatment, an ultraviolet ozone method, a corona method or a plasma method is preferably used. By conducting the lyophilic treatment on the surface contacted with a coupling agent, an application liquid spreads on the surface and an active layer having a uniform thickness can be formed. Further, in the ultraviolet ozone method, a pattern of lyophilic portion and lyophobic portion can be formed on the electrode surface by using a mask defining ultraviolet irradiation area.

The active layer possessed by the organic photoelectric conversion element of the present invention is used as a photoactive layer which converts light energy into electric energy, and functions as a layer for electricity generating source of the photoelectric conversion element. Generally, each cell of a photoelectric conversion element contains one active layer which converts light energy into electric energy; however, there are cases containing two or more layers in order to obtain higher electricity generating efficiency, as is described in, for example, Science,2007, Vol. 317, pp. 222-225.

The active layer possessed by the organic photoelectric conversion element of the present invention includes an electron-donating compound and an electron-accepting compound, and a conjugated polymer compound is preferred as the electron-donating compound. The electron-donating compound and the electron-accepting compound can be used separately in independent layers of a laminate, or they may also be dispersed together in a single layer of a mixture.

The conjugated polymer compound used in the present invention means, for example, (1) a polymer substantially composed of a structure in which double bonds and single bonds are alternately arranged, (2) a polymer substantially composed of a structure in which double bonds and single bonds are arranged through nitrogen atoms, (3) a polymer substantially composed of a structure in which double bonds and single bonds are alternately arranged and a structure in which double bonds and single bonds are arranged through nitrogen atoms. Specific examples of the conjugated polymer compound include polymer compounds in which one or more groups selected from the group consisting of an unsubstituted or substituted fluorenediyl group, an unsubstituted or substituted benzofluorenediyl group, an unsubstituted or substituted dibenzofurandiyl group, an unsubstituted or substitute dibenzothiophenediyl group, an unsubstituted or substitute carbazolediyl group, an unsubstituted or substitute thiophenediyl group, an unsubstituted or substitute furandiyl group, an unsubstituted or substitute pyrrolediyl group, an unsubstituted or substitute benzothiadiazolediyl group, an unsubstituted or substitute triphenylaminediyl group and an unsubstituted or substitute group expressed by the formulas 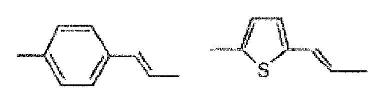 are used as repeating units and the repeating units are bonded to each other directly or through linking groups. From the viewpoint of charge transport property, the conjugated polymer compound preferably contains a thiophene ring structure, and more preferably contains a thiophenediyl group as a repeating unit.

Examples of the electron-accepting compound used in the present invention include oxadiazole derivatives, anthraquinodimethane and its derivatives, benzoquinone and its derivatives, naphthoquinone and its derivatives, anthraquinone and its derivatives, tetracyanoanthraquinodimethane and its derivatives, fluorenone derivatives, diphenyldicyanoethylene and its derivatives, diphenoquinone derivatives, metal complexes of 8-hydroxyquinoline and its derivatives, polyquinoline and its derivatives, polyquinoxaline and its derivatives, polyfluorene and its derivatives, fullerenes such as C₆₀ and their derivatives, phenanthrene derivatives such as bathocuproin, metal oxides such as titanium oxide and zinc oxide, compound semiconductors such as CdSe, carbon nanotube and others. The electron-accepting compound is preferably titanium oxide, carbon nanotube, fullerene or its derivative, and particularly preferably fullerene or its derivative.

Examples of the fullerene include C₆₀ fullerene, C₇₀ fullerene, C₇₆ fullerene, C₇₈ fullerene, C₈₄ fullerene and others.

A fullerene derivative means a compound in which at least a portion of the fullerene is modified. Specific examples of C₆₀ fullerene derivatives include the followings.

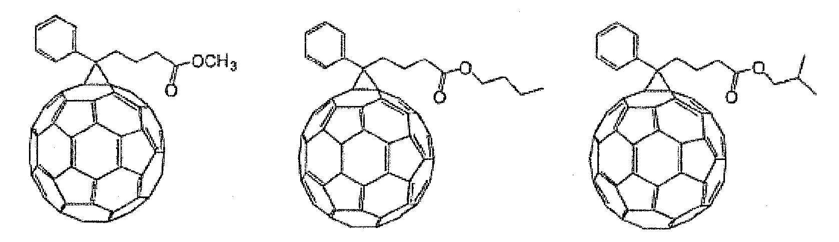

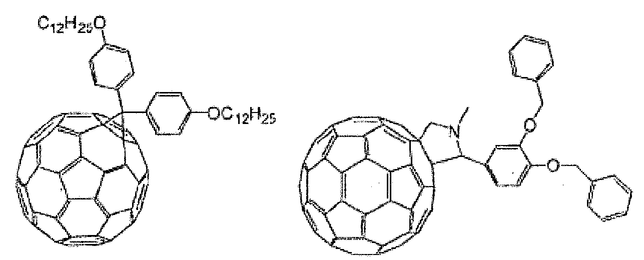

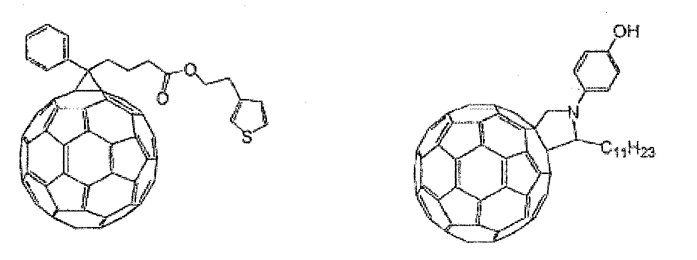

Further, specific examples of C₇₀ fullerene derivatives include the followings.

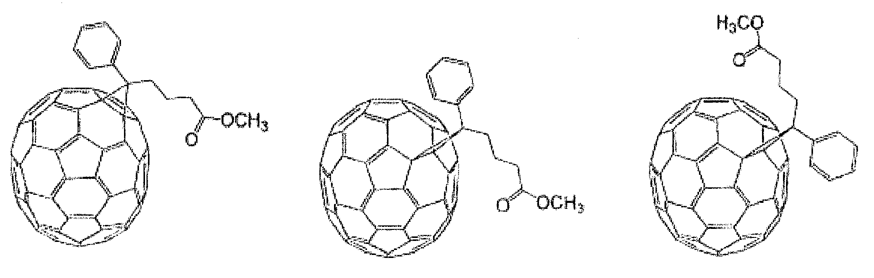

An application method may be used to form the active layer contained in the organic photoelectric conversion element of the present invention. After a coupling agent comes into contact with the active layer side of the surface, the active layer can be formed by applying an application liquid containing materials used to form the active layer onto the electrode surface on which the lyophilic treatment was conducted using a prescribed application method. By applying an application liquid containing either materials of the electron-donating compound or those of the electron-accepting compound to form a layer, followed by applying an application liquid containing the other materials on the surface of the formed layer, a laminate can be obtained in which the electron-donating compound and the electron-accepting compound are used separately in independent layers. Alternatively, by applying an application liquid containing the electron-donating compound and the electron-accepting compound, a mixture can be obtained in which the electron-donating compound and the electron-accepting compound are homogeneously mixed within a layer.

The application liquid includes materials for a layer to be formed and a solvent. As the solvent of the application liquid, one solvent exhibiting a given boiling point may be used solely, or a plurality of solvents may be used in combination. A solvent constituting the application liquid of the present invention preferably dissolves or highly disperses materials for a layer to be formed. Examples of the solvent include chlorinated aliphatic hydrocarbon solvents such as chloroform, methylene chloride, 1,1-dichloroethane, 1,2-dichloroethane, 1,1,1-trichloroethane and 1,1,2-trichloroethane; chlorinated aromatic hydrocarbon solvents such as chlorobenzene, o-dichlorobenzene, m-dichlorobenzene, p-dichlorobenzene and 1,2,4-trichlorobenzene; aliphatic ether solvents such as tetrahydrofuran and 1,4-dioxane; aromatic ether solvents such as anisole and ethoxybenzene; aromatic hydrocarbon solvents such as toluene, o-xylene, m-xylene, p-xylene, ethylbenzene, p-diethylbenzene, mesitylene, propylbenzene, isopropylbenzene, butylbenzene, isobutylbenzene, s-butylbenzene, tetralin and cyclohexylbenzene; aliphatic hydrocarbon solvents such as cyclohexane, methylcyclohexane, pentane, hexane, heptane, octane, nonane, decane, decalin and bicyclohexyl; aliphatic ketone solvents such as acetone, methyl ethyl ketone, methyl isobutyl ketone, cyclohexanone, 2-heptanone, 3-heptanone, 4-heptanone, 2-octanone, 2-nonanone and 2-decanone; aromatic ketone solvents such as acetophenone; aliphatic ester solvents such as ethyl acetate and butyl acetate; aromatic ester solvents such as methyl benzoate, butyl benzoate and phenyl acetate; aliphatic polyhydric alcohol solvents and aliphatic polyhydric alcohol derivative solvents such as ethylene glycol, ethylene glycol monobutyl ether, ethylene glycol monoethyl ether, ethylene glycol monomethyl ether, 1,2-dimethoxyethane, propylene glycol, 1,2-diethoxymethane, triethylene glycol diethyl ether and 2,5-hexanediole; aliphatic alcohol solvents such as methanol, ethanol, propanol, isopropanol and cyclohexanol; aliphatic sulfoxide solvents such as dimethyl sulfoxide; and aliphatic amide solvents such as N-methyl-2-pyrrolidone and N,N-dimethylformamide.

Particularly, as a solvent of an application liquid including a conjugated polymer compound, chlorobenzene, o-dichlorobenzene, 1,2,4-trichlorobenzene, xylene, ethylbenzene, isopropylbenzene, anisole, mesitylene, butylbenzene, isobutylbenzene, cyclohexylbenzene and tetralin are preferred among them.

An application method can be selected depending on the utility form of the organic photoelectric conversion element of the present invention. For example, when intermittent pattern formation of an active layer is conducted for the purpose of preparing modules in which a plurality of the organic photoelectric conversion element are integrated on the same substrate, a printing method using any one printing plate of an intaglio printing plate, a relief printing plate, a planographic printing plate and a stencil printing plate is preferable. From the viewpoint of being able to form a uniform thin film, a gravure printing method which is one of the printing methods using an intaglio printing plate is more preferred. When uniform film formation on the whole substrate is conducted for the purpose of obtaining a large area element, a slit coating method, a capillary coating method, a gravure coating method, a microgravure coating method, a bar coating method, a knife coating method and a spin coating method are preferred. When active layers of different colors are finely colored within the same substrate surface for the purpose of obtaining a photoelectric conversion element having high level color and designability, either a nozzle coating method or an ink jet printing method can be selected.

One embodiment of the organic photoelectric conversion element of the present invention is an organic photoelectric conversion element comprising a first electrode and a second electrode, wherein at least one of the first electrode and the second electrode is transparent, an active layer having a function of converting light energy into electric energy, i.e., a photoelectric conversion function, is located between the first electrode and the second electrode.

The organic photoelectric conversion element of the present invention may also comprise an intermediate layer having functions to enhance electricity generating properties, process durability and others, for example, a property to selectively take out electrons or holes, a property to reduce the energy barrier between an electrode and an active layer, or the film-forming property upon forming a film contained in a laminate or a property to lessen the damage inflicting on the lower layer of the film, between an electrode and an active layer. The intermediate layer may be included as a lower layer and/or an upper layer of an active layer, and may be located between the first electrode and the active layer. The intermediate layer can be formed, for example, by a gas phase method such as a vapor deposition method, a sputtering method or a laser ablation method or a wet-type method such as a sol-gel method, a spray coating method, a printing method or an application method. Examples of an intermediate layer having a property of selectively taking out holes include a layer including poly(ethylenedioxythiophene) (PEDOT) and others. Examples of an intermediate layer having a property of selectively taking out electrons include a layer including titanium oxide, zinc oxide or tin oxide and others.

The organic photoelectric conversion element of the present invention generates photovoltaic power between the electrodes by irradiation of light such as sun light from a transparent or translucent electrode, and is capable of operating as an organic thin film solar cell. By integrating a plurality of organic thin film solar cells, an organic thin film solar cell module may be assembled.

The organic photoelectric conversion element of the present invention causes a photoelectric current to flow when a voltage is applied between the electrodes, and light irradiation is conducted from a transparent or translucent electrode, and is capable of operating as an organic light sensor. Additionally, the organic photoelectric conversion element of the present invention may be used as an organic image sensor including a light receiving section which is the organic light sensor, a driver circuit which detects the output of signal current generated by the organic light sensor and reads the signal charge, and a wiring which connects the organic light sensor and the driver circuit. The organic light sensor can be used with color filters attached in the light incident surface side in order to provide color selectivity of detected light. Alternatively, a plurality of organic light sensors having light absorbing properties which are highly selective to each of the three primary colors of light may be used. The driver circuit may include an IC chip composed of transistors made from single crystal silicon, or compound semiconductors such as polycrystalline silicon, amorphous silicon, cadmium selenide and others, and thin film transistors using conjugated organic compound semiconductors such as pentacene. The organic image sensor is expected to provide advantages of achieving low manufacturing costs and of requiring small installing areas in producing image sensor elements used in scanners, digital cameras, digital video cameras and others as compared to the existing image sensors using charge coupled devices (CCD) or complementary metal oxide semiconductors (CMOS). Because of the diversity of the conjugated compounds, organic light sensors having various optical sensitivities are available, and thus organic image sensors having functions corresponding to various utilizations can be provided.

### EXAMPLES

Hereinafter, the present invention will be further described in detail with reference to examples; however, the present invention is not limited to these examples.

### Example 1

### (Preparation of First Electrode)

A glass substrate on which an ITO film with a thickness of 150 nm was provided by a sputtering method was washed with acetone, and then was subjected to an ultraviolet ozone treatment, and an ITO electrode having a clean surface was prepared. Octadecyltrichlorosilane (OTS) (manufactured by Tokyo Chemical Industry Co., Ltd., Product Name: n-octadecyltrichlorosilane) as a coupling agent and decane as a solvent were mixed to obtain a solution in which the OTS concentration was 0.5% by weight. The ITO electrode was immersed in the resulting solution, and the solution was left still at 27°C for 1 minute. Then, the ITO electrode was pulled out of the solution and was rinsed with decane, and was subjected to a heat treatment at 120°C for 30 minutes, and an ITO electrode coated with OTS was obtained. A lyophilic treatment was conducted on the OTS-coated ITO electrode for 15 minutes with an ultraviolet ozone irradiation apparatus equipped with a low pressure mercury lamp (manufactured by Technovision Corporation, Model: UV-312) and a first electrode 1 was obtained.

### (Preparation of Organic Photoelectric Conversion Element)

Poly(3-hexylthiophene) (P3HT) as a conjugated polymer compound (manufactured by MERK LTD., Product Name: lisicon SP001, lot. EF431002) and PCMB as a fullerene derivative (manufactured by Frontier Carbon Corporation, Product Name: E100, lot. 7B0168-A) were added to an ortho-dichlorobenzene solvent so that the P3HT concentration was 1.5% by weight and the PCBM concentration was 1.2% by weight, and the resulting solution was agitated at 70°C for 2 hours. Then, the solution was filtered with a filter of 0.2 µm in pore size, and an application solution 1 was prepared. The application solution 1 was applied onto the first electrode 1 by spin coating to form an active layer. Then the active layer was heat treated at 150°C for 3 minutes under nitrogen gas atmosphere. The thickness of the active layer after the heat treatment was about 100 nm. Then, on the surface of the active layer, LiF was vapor-deposited in a thickness of 2 nm, followed by vapor deposition of Al in a thickness of 70 nm with a vacuum vapor deposition machine, sequentially. The degree of vacuum during vapor deposition was 2 to 9 × 100⁻⁴ Pa in all cases. The shape of an organic thin film solar cell which was the obtained organic photoelectric conversion element was a square of 2 mm × 2 mm in size. Light having a radiation luminance of 100 mw/cm² was irradiated through AMI. 5G filter, and the current and voltage obtained were measured with a solar simulator (manufactured by Yamashita Denso, Product Name: YSS-80) and the photoelectric conversion efficiency of the resulting organic thin film solar cell was determined. The results are shown in Table 1 below.

### Comparative Example 1

A glass substrate on which an ITO film with a thickness of 150 nm was provided by a sputtering method was washed with acetone, and then was subjected to an ultraviolet ozone treatment, and an ITO electrode having a clean surface was prepared. An organic thin film solar cell was prepared in the same manner as in Example 1 except for replacing the ITO electrode with the first electrode, and the photoelectric conversion efficiency was determined. The results are shown in Table 1 below.

**Table 1**

| | photoelectric conversion efficiency (%) |
|---|---|
| Example 1 | 1.34 |
| Comparative Example 1 | 0.74 |

### Example 2

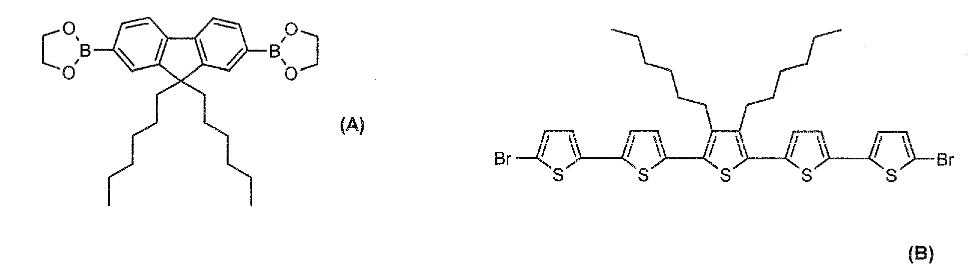

### (Synthesis of Polymer A)

Into a 2 L four-necked flask, an atmosphere of which was replaced with argon, a compound (A) (7.928 g, 16.72 mmol), a compound (B) (13.00 g, 17.60 mmol), methyltrioctylammonium chloride (Product Name: aliquat 336, manufactured by Aldrich, CH₃N[(CH₂)₇CH₃]₃Cl, density 0.884 g/ml, 25°C, Trademark of Henkel Corporation) (4.979 g), and 405 ml of toluene were placed, and then the reaction system was bubbled with argon for 30 minutes while stirring. Diohlorobis(triphenylphosphine) palladium (II) (0.02 g) was added to the reaction solution, the reaction solution was heated to 105°C, and 42.2 ml of a 2 mol/L aqueous sodium carbonate solution was added dropwise to the reaction solution while stirring. The reaction was allowed to proceed for 5 hours from the completion of the dropwise addition, then phenyl boronic acid (2.6 g) and 1.8 mL of toluene were added to the reaction solution, and the reaction solution was stirred at 105°C for 16 hours. To the reaction solution, 700 mL of toluene and 200 mL of a 7.5% aqueous solution of sodium diethyldithiocarbamate trihydrate were added and stirred at 85°C for 3 hours. The aqueous layer of the reaction solution was removed, and the organic layer was washed twice with 300 mL of ion-exchange water having a temperature of 60°C, once with 300 mL of 3 % acetic acid having a temperature of 60°C, and still three times with 300 mL of ion-exchange water having a temperature of 60°C. Then, the organic layer was passed through a column packed with celite, alumina and silica, and the column was washed with 800 mL of hot toluene. The resulting solution was concentrated to 700 mL, and then poured into 2 L of methanol to reprecipitate. The resulting polymer was collected by filtration, and washed with 500 mL of methanol, acetone and methanol. The washed polymer was dried at 50°C overnight under vacuum, and thus 12.21 g of a pentathienyl-fluorene copolymer (hereinafter referred to as "polymer (A)") represented by the following formula: 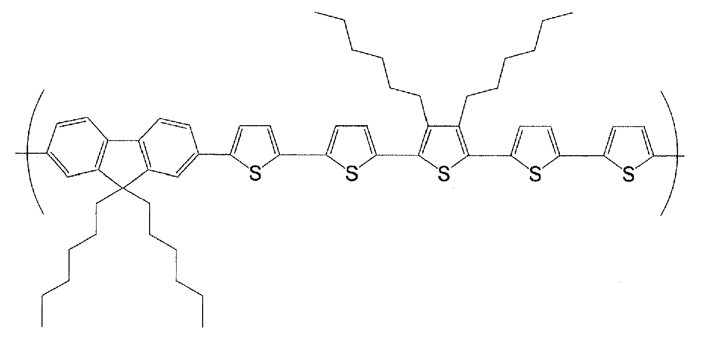 was obtained. The number average molecular weight and the weight average molecular weight, in terms of polystyrene, of the polymer (A) were 5.4 × 10⁴ and 1..1 × 10⁵, respectively.

### (Preparation of Organic Thin Film Solar Cell)

The polymer (A) as a conjugated polymer compound and PCBM as a fullerene derivative were added to an ortho-dichlorobenzene solvent so that the polymer (A) concentration was 0.5% by weight and the PCBM concentration was 1.5% by weight. The resulting solution was stirred at 70°C for 2 hours, and then, the solution was filtered with a filter of 0.2 µm in pore size, and an application solution 2 was prepared. The application solution 2 was applied onto a first electrode 1 which was prepared in the same manner as in Example 1 by spin coating to form an active layer. The active layer was then dried in a vacuum at room temperature for 60 minutes. The thickness of the active layer after drying was about 100 nm. Then, on the surface of the active layer, LiF was vapor-deposited in a thickness of 2 nm, followed by vapor deposition of Al in a thickness of 70 nm with a vacuum vapor deposition machine, sequentially. The degree of vacuum during vapor deposition was 2 to 9 × 10⁻⁴ Pa in all cases. The shape of an organic thin film solar cell which was the obtained organic photoelectric conversion element was a square of 2 mm × 2 mm in size. The photoelectric conversion efficiency of the resulting organic thin film solar cell was determined in the same manner as in Example 1. The results are shown in Table 2 below.

### Comparative Example 2

An organic thin film solar cell was prepared in the same manner as in Example 2 except for using an ITO electrode prepared in the same manner as in Example 1, and the photoelectric conversion efficiency was determined. The results are shown in Table 2 below.

**Table 2**

| | photoelectric conversion efficiency (%) |
|---|---|
| Example 2 | 2.21 |
| Comparative Example 2 | 1.60 |

### Example 3

### (Preparation of Organic Photoelectric Conversion Element)

PEDOT (manufactured by H.C. Starck - V TECH Ltd., Product Name: Bayton P AI4083, lot. HCD070109) was applied onto a first electrode 1 which was prepared in the same manner as in Example 1 by spin coating. Drying at 150°C for 30 minutes was conducted in the air. Then, an application liquid 1 prepared in the same manner as in Example 1 was applied by spin coating to form an active layer. The active layer was heat treated under nitrogen gas atmosphere at 150°C for 3 minutes. The thickness of the active layer after drying was about 100 nm. Then, on the surface of the active layer, LiF was vapor-deposited in a thickness of 2 nm, followed by vapor deposition of Al in a thickness of 70 nm with a vacuum vapor deposition machine, sequentially. The degree of vacuum during vapor deposition was 2 to 9 × 10⁻⁴ Pa in all cases. The shape of an organic thin film solar cell which was the obtained organic photoelectric conversion element was a square of 2 mm × 2 mm in size. The photoelectric conversion efficiency of the resulting organic thin film solar cell was determined in the same manner as in Example 1. The results are shown in Table 3 below.

### Comparative Example 3

An organic thin film solar cell was prepared in the same manner as in Example 3 except for using an ITO electrode prepared in the same manner as in Example 1, and the photoelectric conversion efficiency was determined. The results are shown in Table 3 below.

**Table 3**

| | photoelectric conversion efficiency (%) |
|---|---|
| Example 3 | 1.52 |
| Comparative Example 3 | 0.60 |

### INDUSTRIAL APPLICABILITY

The organic photoelectric conversion element of the present invention has high photoelectric conversion efficiency, thus is very useful.

## Claims

1. An organic photoelectric conversion element comprising a first electrode, a second electrode and an active layer, wherein the active layer is located between the first electrode and the second electrode and contains an electron-donating compound and an electron-accepting compound, and the active layer side of the first electrode surface is treated with a coupling agent followed by a lyophilic treatment.

2. The organic photoelectric conversion element according to claim 1, wherein the electron-donating compound is a conjugated polymer compound, and the electron-accepting compound is a fullerene derivative.

3. The organic photoelectric conversion element according to claim 1, wherein the coupling agent is an organic silicon compound, organic aluminum compound, organic zirconium compound or organic titanium compound, each having a group which forms a hydroxyl group when reacted with water.

4. The organic photoelectric conversion element according to claim 1, wherein the coupling agent is vinyltrichlorosilane, vinyltrimethoxysilane, vinyltriethoxysilane, 2-(3,4-epoxycyclohexyl)ethyltrimethoxysilane, 3-glycidoxypropyltrimethoxysilane, 3-glycidoxypropylmethyldiethoxysilane, 3-glycidoxypropyltriethoxysilane, p-styryltrimethoxysilane, 3-methacryloxypropylmethyldimethoxysilane, 3-methacryloxypropyltrimethoxysilane, 3-methacryloxypropylmethyldiethoxysilane, 3-methacryloxypropyltriethoxysilane, 3-acryloxypropyltrimethoxysilane, N-2-(aminoethyl)-3-aminopropylmethyldimethoxysilane, N-2-(aminoethyl)-3-aminopropyltrimethoxysilane, N-2-(aminoethyl)-3-aminopropyltriethoxysilane, 3-aminopropyltrimethoxysilane, 3-aminotriethoxysilane, 3-triethoxysilyl-N-(1,3-dimethyl-butylidene)propylamine, N-phenyl-3-aminopropyltrimethoxysilane, N-(vinylbenzyl)-2-aminoethyl-3-aminopropyltrimethoxysilane hydrochloride, 3-ureidopropyltriethoxysilane, 3-chloropropyltrimethoxysilane, 3-mercaptopropylmethyldimethoxysilane, 3-mercaptopropyltrimethoxysilane, bis(triethoxysilylpropyl) tetrasulfide, 3-isocyanatopropyltriethoxysilane, tetramethoxysilane, tetraethoxysilane, methyltrimethoxysilane, methyltriethoxysilane, dimethyltriethoxysilane, phenyltriethoxysilane, hexamethyldisilazane, hexyltrimethoxysilane, decyltrimethoxysilane, butyltrichlorosilane, cyclohexyltrichlorosilane, decyltrichlorosilane, dodecyltrichlorosilane, octyltrichlorosilane, octadecyltrichlorosilane, tetradecyltrichlorosilane, aluminum isopropylate, mono sec-butoxyaluminum diisopropylate, aluminum sec-butyrate, aluminum ethylate, ethylacetoacetatoaluminum diisopropylate, aluminum tris(ethylacetoacetate), alkylacetoacetatoaluminum diisopropylate, monoacetylacetonatoaluminum bis(ethylacetoacetate), aluminum tris(acetylacetonate), aluminum monoisopropoxymonooleoxyethylacetoacetate, cyclic aluminum oxide isopropylate, cyclic aluminum oxide octylate, cyclic aluminum oxide stearate, zirconium n-propylate, zirconium n-butyrate, zirconium tetraacetylacetonate, zirconium monoacetylacetonate, zirconium bisacetylacetonate, zirconium monoethylacetoacetate, zirconium acetylacetonate bisethylacetoacetate, zirconium acetate, zirconium monostearate, tetraisopropyl titanate, tetra-n-butyl titanate, butyl titanate dimer, tetra(2-ethylhexyl)titanate, tetramethyl titanate, titanium acetylacetonate, titanium tetraacetylacetonate, titanium ethylacetoacetate, titanium octanediolate, titanium lactate, titanium triethanolaminate, or polyhydroxytitanium stearate.

5. The organic photoelectric conversion element according to claim 1, wherein the coupling agent is octadecyltrichlorosilane.

6. The organic photoelectric conversion element according to claim 2, wherein the conjugated polymer compound has a repeating unit including one or more groups selected from the group consisting of a fluorenediyl group, a benzofluorenediyl group, a dibenzofurandiyl group, a dibenzothiophenediyl group, a carbazolediyl group, a thiophenediyl group, a furandiyl group, a pyrrolediyl group, a benzothiadiazolediyl group, a triphenylaminediyl group and a group expressed by the formulas 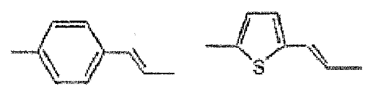 as a backbone.

7. The organic photoelectric conversion element according to claim 2, wherein the conjugated polymer compound is a pentathienyl-fluorenone copolymer.

8. The organic photoelectric conversion element according to claim 2, wherein the fullerene derivative is any one of the compounds represented by the following formulas.

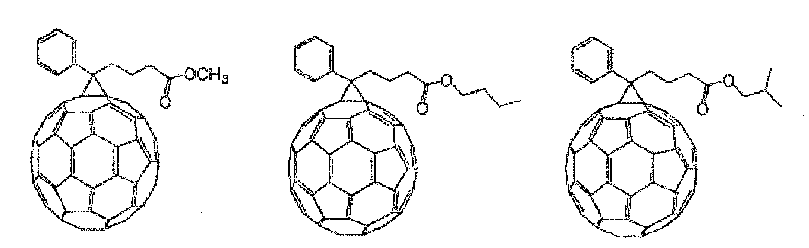

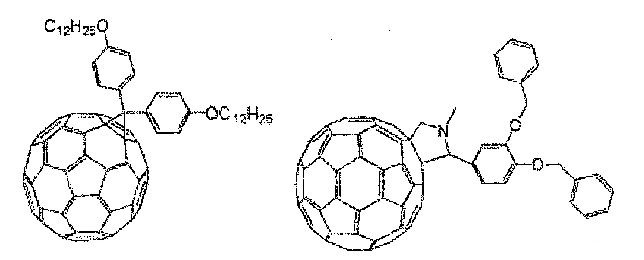

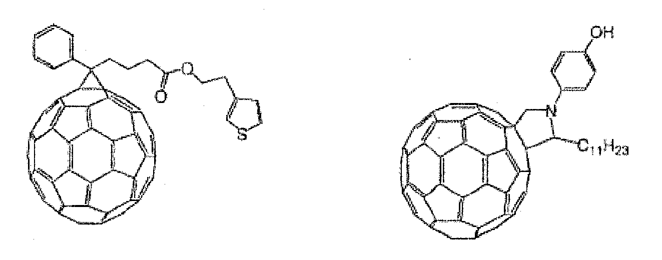

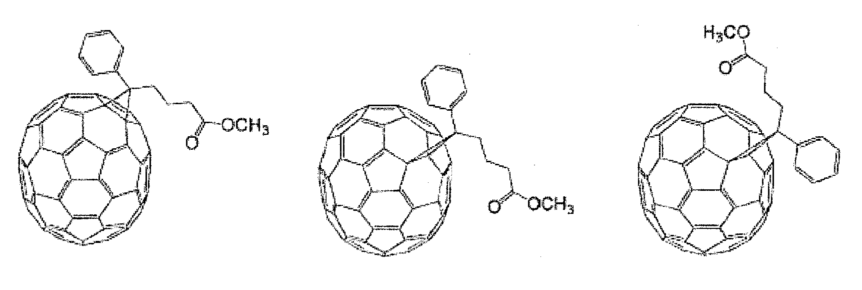

9. A method for producing the organic photoelectric conversion element according to claim 1, the method comprising a step of preparing a first electrode by making a coupling agent come into contact with a surface of an electrode followed by conducting a lyophilic treatment on the surface which the coupling agent contacted.

10. The production method according to claim 9, wherein the lyophilic treatment is conducted by an ultraviolet ozone method, a corona method or a plasma method.

11. An image sensor comprising the organic photoelectric conversion element according to claim 1.
